# EUROPEAN PATENT APPLICATION

(11) **EP 2 163 920 A1**
(43) Date of publication of application: **17.03.2010**
(21) Application number: 08765582.5
(22) Date of filing: 13.06.2008
(51) Int. Cl.: G02B 5/02, G02B 1/10, G02B 1/11, G09F 9/00, H05K 9/00

(54) **OPTICAL FILTER FOR DISPLAY, AND DISPLAY AND PLASMA DISPLAY PANEL PROVIDED WITH SAME**

(30) Priority: 15.06.2007 JP 2007159124
(71) Applicant: Bridgestone Corporation, Tokyo 104-0031 (JP)
(72) Inventor: KAMEI, Hideyuki, Yokohama-shi Kanagawa 244-8510 (JP); NAKAMURA, Hiroshi, Yokohama-shi Kanagawa 244-8510 (JP); SUGIMACHI, Masato, Yokohama-shi Kanagawa 244-8510 (JP)
(74) Representative: Whalley, Kevin
(86) International application number: PCT/JP2008/060872
(87) International publication number: WO 2008/153139

(57) **Abstract**

An optical filter for a display having both excellent antiglare property and transparency, and a process for producing the optical filter are provided. The optical filter of the invention includes: a structure including a film and a mesh-shaped metal conductive layer provided on one surface of the film; and an antiglare layer provided on the one surface of the mesh-shaped metal conductive layer, the antiglare layer including a resin and fine particles dispersed in the resin, the fine particles protruding from the surface of the antiglare layer. In addition, the optical filter of the invention includes: a structure including a film and a mesh-shaped metal conductive layer provided on one surface of the film; a sealing layer for filling spaces of the mesh defined by the mesh-shaped metal conductive layer, the sealing layer being provided on the one surface of the mesh-shaped metal conductive layer; and an antiglare layer provided on the sealing layer, the antiglare layer including a resin and fine particles dispersed in the resin, the fine particles protruding from the surface of the antiglare layer.

## Description

### Background of the Invention

### 1. Field of the invention

The present invention relates to an optical filter for adding various functions such as antireflection, near-infrared shielding and electromagnetic wave shielding to various displays such as plasma display panel (PDP), cathode-ray-tube (CRT) display, liquid crystal display, organic EL (FED) electroluminescence display and field emission display (FED) including surface-conduction electron-emitter display (SED), and a display provided with the optical filter, particularly PDP.

### 2. Description of the Related Art

In flat-panel displays such as a liquid crystal display, plasma display panel (PDP) and organic EL display, and CRT Display, a problem is known that external light is reflected on a surface of the display and creates difficulty to see visual information on the display. Therefore, various countermeasures including provision of various optical films such as an antireflection film on the displays are taken.

In recent years, image magnification has entered the mainstream of the displays, and use of next-generation PDP has been generalized. However, the PDP high-frequency wave pulse discharge is carried out in the light emitting part of the PDP for displaying image. Therefore, unnecessary electromagnetic waves or infrared rays which cause malfunction of infrared remote controls are possibly radiated. Thus, for this purpose, as for the PDP, various antireflection conductive films (electromagnetic wave shielding and light transmissive materials) for PDP have been proposed. Examples of the electromagnetic wave shielding light transmitting materials include (1) a transparent film having a metallic silver-containing transparent conductive thin layer thereon; (2) a transparent film having a conductive mesh layer consisting of network-patterned metallic wire or conductive fiber thereon; (3) a transparent film having network-patterned copper foil layer obtained by etching-processing copper foil so as to have opening parts thereon; and (4) a transparent film having a mesh-shaped conductive ink layer formed by printing thereon.

In addition, since visibility of an image displayed on a display is decreased when a surface of a filter is scratched, a filter for a display having a hard coat layer is known. Furthermore, in a large size display including a conventional PDP, there has been a problem that it is hard to watch the image displayed on the display due to reflection of rays radiated from an external light source such as a fluorescent lamp. Therefore, a filter for a display having an antireflection layer is widely used.

A laminated filter for a display may include an electromagnetic wave shielding layer, a hard coat layer and an antireflection layer, depending upon an application. For example, JP2004-163752 discloses a filter for a display in which an electromagnetic wave shielding layer, a hard coat layer and an antireflection layer are laminated in this order on a transparent substrate.

Further, JP2002-374094 discloses a filter for a display in which a lattice-shaped antiglare layer is provided on a transparent substrate and a lattice-shaped conductive layer is provided on the antiglare layer. As an illustrated antiglare layer, a black ink layer in which inorganic pigment such as carbon black is dispersed in a synthetic resin such as urethane resin and acrylic resin.

### Disclosure of the Invention

### Problem to be solved by the Invention

It is desirable to improve the antiglare property of a conventional filter for a display. That is to say, it is sometimes difficult to recognize images, such as letters, on the display in a room, because of the reflection of light, e.g., from a fluorescent lamp. Therefore, it is desired that the filter has an improved high anti-glare property, in order to prevent the display from reflecting off of the external environment.

In order to obtain a high antiglare property, JP2002-374094, for example, proposes the provision of a black antiglare layer under a mesh conductive layer. There was a possibility, however, that the black anti-glare layer does not ensure sufficient transparency because of reduction of haze in the anti-reflection layer.

Thus, an object of the present invention is to provide an optical filter having both excellent antiglare property and transparency.

Further, another object of the invention is to provide an optical filter, which can be easily prepared, having both excellent antiglare property and transparency.

A further object of the invention is to provide an optical filter for a display, which can be easily prepared and is light and thin, having both excellent antiglare property and transparency, and good electromagnetic wave shielding property.

A still another object of the present invention is to provide an optical filter suitable for PDP, which can be easily prepared, having both excellent antiglare property and transparency and good electromagnetic wave shielding property.

Yet another object of the present invention is to provide a display wherein the above-mentioned optical filter having excellent properties is attached to a surface of a glass plate for displaying images included in the display.
Yet another object of the present invention is to provide a plasma display panel (PDP) wherein the above-mentioned optical filter having excellent properties is attached to a surface of a glass plate for displaying images included in the display.

### Means for solving problem

The present invention provides:
An optical filter for a display comprising:
   a structure comprising a film (generally, one transparent film) and a mesh-shaped metal conductive layer provided on one surface of the film; and
   an antiglare layer provided on the one surface of the mesh-shaped metal conductive layer, the antiglare layer comprising a resin and fine particles dispersed in the resin, the fine particles protruding from the surface of the antiglare layer; and
   an optical filter for a display comprising:
      a structure comprising a film and a mesh-shaped metal conductive layer provided on one surface of the film;
      a sealing layer for filling spaces of the mesh defined by the mesh-shaped metal conductive layer, the sealing layer being provided on the one surface of the mesh-shaped metal conductive layer; and
      an antiglare layer provided on the sealing layer, the antiglare layer comprising a resin and fine particles dispersed in the resin, the fine particles protruding from the surface of the antiglare layer.

In the former optical filter, the thickness of the antiglare layer is preferably greater than the height of the mesh in the metal conductive layer by 1 µ m or more.

The above-mentioned height from the surface of the film to the surface of the antiglare layer (the thickness of the antiglare layer) is calculated from the difference obtained by measuring the surface of the film and the surface of the antiglare layer formed on the surface of the film, by using a surface roughness meter (trade name: SURFCOM480A available from Tokyo Seimitsu Co., Ltd), in accordance with JIS B0601-2001.

The height from the surface of the antiglare layer to the surface of the exposed fine particles (hereinafter, referred to as particles) can be calculated from a profile curve obtained by measuring by using the surface roughness meter (trade name: SURFCOM480A available from Tokyo Seimitsu Co., Ltd) in accordance with JIS B0601-2001. This was carried out at the measurement length of 2mm.

Preferred embodiments of the optical filter for a display according to the present invention are described as follows:

(1) The thickness of the antiglare layer is smaller than mean particle size of the particles. Hence, the antiglare layer having excellent antiglare property can be easily prepared.

(2) The antiglare layer, or the combination of the sealing layer and the antiglare layer can be formed by applying a coating liquid comprising the resin and the particles dispersed in an organic solvent.

(3) The particles have a mean particle size of 1 to 10 µ m.

(4) The particles are organic resin particles or inorganic particles. The organic resin particles are preferred, and particularly at least one kind of particles selected from a group consisting of cross-linked acrylic resin particles, cross-linked styrene resin particles and cross-linked acrylic-styrene copolymer particles are preferred.

The inorganic particles are at least one kind of metal oxide particles selected from the group comprising ITO, TiO₂, ZrO₂, CeO₂, SiO₂, Al₂O₃, Y₂O₃, La₂O₃ LaO₂ and Ho₂O₃.

(5) Resin of the antiglare layer is ultraviolet curable resin.

(6) In the antiglare layer, there is substantially no difference between the refractive index of the resin in which the particles are dispersed and that of the particles, particularly not more than 0.03. Based on this, the transparency of the antiglare layer can be enhanced

(7) The sealing layer has the same composition as that of the anti-glare layer. The antiglare property can be stably obtained. Further, productivity is also enhanced.

(8) The antiglare layer functions as a hard coat layer. It is not necessary to form a hard coat layer.

(9) The mean height from the surface of the antiglare layer to the surface of the protruded particles is in the range of 10 to 50%, particularly in the range of 10 to 40% based on the mean particle size of the particles.

(10) The mesh-shaped metal conductive layer has a thickness of 1 to 15 µ m.

(11) Transmission image sharpness established in JIS-K-7105 is not less than 150. (The determination is carried out, in general, with respect to a laminate comprising a film, a conductive layer and an antiglare layer or a laminate comprising a film, a conductive layer, a sealing layer and an anti-glare layer.)

(12) Reflection image sharpness (reflection angle: 45 degrees) established in JIS-K-7105 is not more than 100. (The determination is carried out, in general, with respect to a laminate comprising a film, a conductive layer and an antiglare layer or a laminate comprising a film, a conductive layer, a sealing layer and an antiglare layer.)

(13) Surface roughness (Ra) of the antiglare layer is in the range of 0.05 to 0.6 µ m. It was determined by using a surface roughness meter (trade name: SURFCOM 480A, available from TOKYO SEIMITSU Co., Ltd) in accordance with JIS B0601-2001.

(14) The film is a transparent plastic film.

(15) The optical filter for a display is an optical filter for a plasma display panel.

(16) The optical filter for a display is an optical filter for a display attached to a glass plate.

Furthermore, the present invention also provides:
a display comprising the abovementioned optical filter for a display (generally speaking, the optical filter is attached to a surface of a glass plate for displaying images); and
a plasma display panel comprising the abovementioned optical filter for a display (generally speaking, the optical filter is attached to a surface of a glass plate for displaying images).

It is preferred that the optical filter for a display is attached to an image-displaying glass plate by bonding the surface which does not carry the conductive layer to the surface of the image-displaying glass plate.

### Effect of the Invention

According to the present invention, an optical filter suitable for a display can be obtained by forming a sealing layer for filling spaces defined by a mesh shaped metal conductive layer. The sealing layer is provided on the surface of the mesh-shaped conductive layer, and an antiglare layer, from which particles are exposed, can be prepared on the sealing layer. Such optical filter of the invention is stable and has excellent anti-glare property and transparency. Further, an optical filter suitable for a display having excellent antiglare property and transparency can be easily obtained by forming an antiglare layer, from which particles are exposed, on a surface of a mesh-shaped conductive layer.

Therefore, the optical filter of the present invention is excellent in visibility of image displayed on a display, and is useful as a filter for a display attached to the surface of optical products such as plasma display panel (PDP) and EL display.

### Brief Description of the Drawings

[Fig. 1] Fig. 1 is a partial schematic sectional view showing a representative example of an optical filter for a display according to the present invention.
[Fig. 2] Fig. 2 is a partial enlarged sectional view showing the optical filter for a display shown in the Fig 1.
[Fig. 3] Fig. 3 is a partial schematic sectional view showing another representative example of the optical filter for a display according to the present invention.
[Fig. 4] Fig. 4 is a partial schematic sectional view showing an embodiment of the optical filter for a display according to the present invention.
[Fig. 5] Fig. 5 is a schematic sectional view showing an embodiment of the optical filter for a display according to the present invention.
[Fig. 6] Fig. 6 is a plane view showing the optical filter for a display with the electrode part shown in the Fig 5.
[Fig. 7] Fig. 7 is a schematic sectional view showing an embodiment of an optical filter, wherein of a state that the optical filter according to the present invention is attached to image- displaying surface of plasma display panel, a kind of display.

### Explanation of reference number

- 11, 31, 41: Transparent film
- 12,42: Sealing layer
- 13, 33, 43: Conductive layer
- 14,34,44: Antiglare layer
- 15, 45: Low refractive index layer
- 16,46: Near-infrared absorption layer
- 17, 47: Transparent adhesive layer

### Description of Preferred Embodiments

The optical filter of the present invention is explained by referring to the figures.

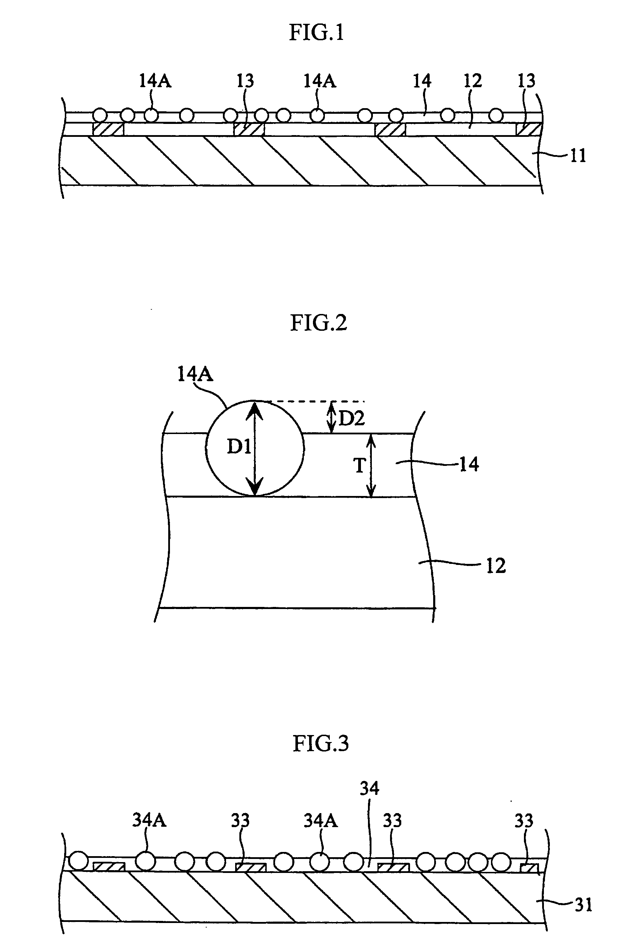

Fig. 1 is a schematic sectional view (central fragmentary view) of the optical filter of the present invention.

The optical filter of the present invention comprises a transparent film 11, a mesh-shaped conductive layer (electromagnetic wave shielding layer) 13 formed on the transparent film 11, a sealing layer 12 for filling spaces of the mesh of the conductive layer 13, and an antiglare layer 14 formed on the conductive layer 13 and the sealing layer 12 (in case the conductive layer 13 is covered with the sealing layer 12, formed on the sealing layer 12). The antiglare layer 14 contains particles 14A therein, which protrude from the surface of the antiglare layer 14.

In the present invention, firstly, the spaces defined by the mesh-shaped conductive layer 13 is filled by the sealing layer 12, to obtain a substantially flat surface. Then, the thin antiglare layer 14 is formed such that the particles 14A protrude from the surface thereof. Thereby, an uneven surface can be easily formed, and the degree of unevenness can be easily controlled. For providing the sealing layer, the antiglare layer preferably has a thickness of 1 to 8 µ m, particularly 1 to 5 µ m.

In order to form the antiglare layer wherein the particles are dispersed in the resin and are protruded from the surface, the thickness of the antiglare layer is preferably smaller than the mean particle size of the particles. Accordingly, the antiglare layer, which has excellent antiglare property, can be easily prepared. If the particles are protruded from the antiglare layer, the thickness of the antiglare layer can also be larger than the mean particle size of the particles.

In order to obtain the excellent antiglare property and transparency, the particles preferably has a mean particle size of 1 to 10 µ m. Preferred examples of the particles are transparent organic resin particles, particularly cross-linked acrylic resin particles, cross-linked styrene resin particles and cross-linked acrylic-styrene copolymer. Further, in order to ensure the antiglare property and transparency, the mesh-shaped conductive layer preferably has the thickness of 1 to *15* µ m. Furthermore, in order to ensure the antiglare property and transparency, it is efficient that the antiglare layer is configured to have a transmission image sharpness established in JIS-K-7105 not less than 150 and a reflection image sharpness (reflection angle: 45 degrees) established in JIS-K-7105 is not more than 100. In this case, the measurement of these sharpnesses is carried out with respect to a laminate comprising a film, a conductive layer, a sealing layer and an anti-glare layer (Fig 1), or a laminate comprising a film, a conductive layer and an antiglare layer (Fig 3).

Considering the above-mentioned points, in the present invention, the mean height of the particles, from the surface of the antiglare layer to the surface of the exposed particles, is preferably in the range of 10 to 50%, particularly in the range of 10 to 40% based on the mean particles of the particles.

Fig 2 shows that a fragmentary enlarged sectional view of the schematic sectional view of the optical filter show in Fig 1. T is the thickness of the antiglare layer 14. The particles 14A having a particle size DI (actually, mean particle size), which is larger than the thickness of the antiglare layer, are embedded in the antiglare layer so that the particles protrudes from the antiglare layer by the length, D2. D2 corresponds to from 10 to 50% (particularly, from 10 to 40%) of mean particle size D1 of the particles.

In the present invention, the height/distance from the surface of the abovementioned film to the surface of the antiglare layer (the thickness of the antiglare layer (T described above)) was calculated from a difference obtained by measuring the surface of the film and the surface of the anti-glare layer formed on the surface of the film by using a surface roughness meter (trade name: SURFCOM480A available from Tokyo Seimitsu Co., Ltd) in accordance with JIS B0601-2001.

The height from the surface of the antiglare layer to the surface of the exposed particles can be calculated from a profile curve obtained by measuring by using the surface roughness meter (trade name: SURFCOM480A available from Tokyo Seimitsu Co., Ltd) in accordance with JIS B0601-2001. This was carried out at a measurement length of 2mm.

The surface roughness (Ra) of the antiglare layer is preferably in the range of 0.05 to 0.6 µm. The measurement is carried out by using the surface roughness meter (trade name: SURFCOM480A from Tokyo Seimitsu Co., Ltd) in accordance with JIS B0601-2001.

The resin of the antiglare layer is preferably an ultraviolet curable resin. Thereby, a hard coat function (function of a hard coat layer) can be easily given to the antiglare layer. Further, the sealing layer has the same composition as that of the antiglare layer. The antiglare property can be stably obtained and productivity is enhanced.

Fig. 3 shows a schematic sectional view (central fragmentary view) of another embodiment of the optical filter for a display of the present invention.

An optical filter of the present invention comprises a transparent film 31, a mesh-shaped conductive layer (electromagnetic wave shielding layer) 33 formed on the transparent film 31 and an antiglare layer 34 provided on the conductive layer 33. The antiglare layer 34 contains particles 34A protruded from the surface of the antiglare layer 34. Excellent anti-glare property and transparency are obtained even if the filter has such the simple structure.
It is particularly efficient when the thickness of the mesh is thin (for example, not more than 5 µ m). In this embodiment, the thickness of the anti-glare layer is preferably greater than the thickness of the mesh of the metal conductive layer by 1 µ m or more.

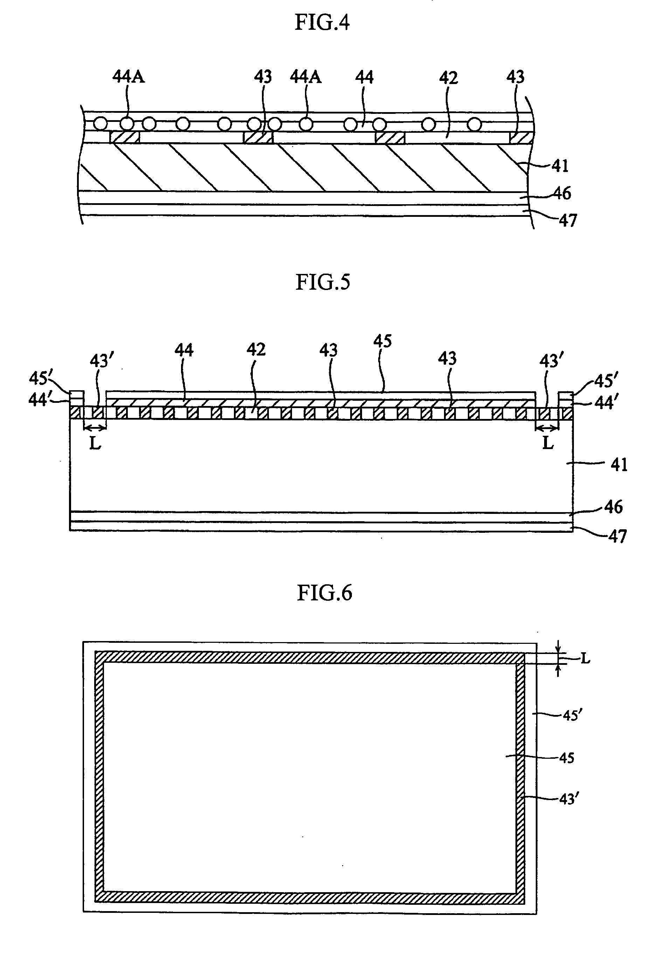

Fig 4 shows a fragmentary schematic sectional view (central fragmentary view) of a preferred embodiment of an optical filter of the present invention. A mesh-shaped conductive layer 43, a sealing layer 42, an antiglare layer 44 comprising particles 44A and a low refractive index layer 45 are formed on one surface of a transparent film 41 in this order. Further, a near-infrared absorption layer 46 is formed on the other surface of the transparent film 41, and a transparent adhesive layer 47 is formed on the near-infrared absorption layer 46.

Fig 5 shows an entire schematic sectional view of a preferred embodiment of the optical filter of Fig 4. A mesh-shaped conductive layer 43, a sealing layer 42, an antiglare layer 44 comprising particles 44A and a low refractive index layer 45 are formed on one surface of a transparent film 41 in this order. Further, a near-infrared absorption layer 46 is formed on the other surface of the transparent film 41, and a transparent adhesive layer 47 is formed on the near-infrared absorption layer 46.

In this embodiment, the antiglare layer 44 has a peripheral antiglare layer 44' at the peripheral/outer area thereof, via a conductive layer-exposed area 43' (generally obtained by removing each layer with a laser). The antiglare layer 45 also has a periphery low refractive index layer 45' outside of a conductive layer-exposed area 43' on the periphery antiglare layer 44'. Electrical conduction can be easily obtained by using the conductive layer-exposed area 43' when the optical filter is attached to PDP. Further, a conductive layer-exposed area may be formed by entirely removing the periphery antiglare layer 44' and the periphery low refractive index layer 45'.

Fig 6 shows a plane view of a preferred example of an optical filter of the present invention, which a frame-shaped conductive layer-exposed area 43' formed at the entire periphery of the antiglare layer 44 and the low refractive index layer 45, and the frame-shaped peripheral antiglare layer 44' and the frame-shaped peripheral low refractive index layer 45' are formed outside of the conductive layer-exposed area 43'.

The conductive layer-exposed area 43' is used as an electrode part for an earth. It is preferable that the width of the peripheral narrow zonal area ("L" in Figs. 5 and 6") is generally in the range of 1 to 100 mm, particularly in the range of 2 to 50mm. It is preferable that the width of the narrow zonal area of the peripheral antiglare layer 44' (and the peripheral low refractive layer 45') is generally in the range of 0.1 to 20mm, particularly in the range of 0.5 to 5mm.

There is no special restriction as to the portion where the conductive layer is exposed, as long as the portion is available as an electrode part for an earth. It is preferable that at least of a part of the periphery of the conductive layer is exposed. For example, it is possible to use the portion having a configuration of island-shaped areas, which are present intermittently in the periphery of the conductive layer. The conductive layer can be exposed in the island-shaped areas. The island-shaped areas may be in any shape such as a rectangle, oval, circle or polygonal shape. Further, the island-shaped areas may have the same or different size from each other. As shown in Fig 5 and 6, it is more preferable that the conductive layer is exposed in the form of a belt at the periphery of the conductive layer surface.

Furthermore, the portion where the conductive layer is exposed it is not limited to the above described configuration. It is also possible that at least a lateral part the conductive layer is partially exposed. With such configuration, it is possible to use the conductive layer as an electrode part for an earth.

The antiglare layer generally has excellent antireflection property and an antireflection layer is often unnecessary. Accordingly, it becomes possible to free set/choose the refractive index of the other layers, and the materials for the layers can be widely chosen. Hence, it is possible to enjoy the cost reduction. When both the antiglare layer and the low refractive layer are used, highly improved antireflection property is obtained, compared to the instance where only the antiglare layer is used.

Formation of the antiglare layer or the combination of the sealing layer and the antiglare layer is preferably carried out by applying a coating liquid which particles are dispersed in a resin and an organic solvent. In this case, it is preferable that the components of the optical filter (e.g. a mesh, a primer layer and a substrate) are free from corrosion by use of an organic solvent, and that high transparency can be obtained. Thus, the resultant optical filter preferably has a haze value of not more than 10%. The haze value is preferably determined by using Full Automatic Direct-Reading Haze Computer (HGM-2DP; manufactured by Suga Shikenki K.K.) according to JIS K 7105 (1981).

An example of the near-infrared absorption layer and the transparent adhesive layer is shown in Fig 4. Alternatively, a near-infrared absorption layer, a neon-cut layer or a transparent adhesive layer, or a combination of two or more of these layers may be employed. Alternatively, an optical filter comprising a transparent adhesive layer having near-infrared absorption function and neon-cut function, an optical filter comprising a near-infrared absorption layer having neon-cut function and a transparent adhesive layer (these are provided on a transparent film in this order) or an optical filter comprising a near-infrared absorption layer, a neon-cut layer and transparent adhesive layer (these are provided on a transparent film in this order) is also preferred.

The above-mentioned conductive layer 13, 33, 43 is a mesh-shaped metal layer or a mesh-shaped metal-containing layer. The mesh-shaped metal layer or the mesh-shaped metal-containing layer is generally formed by etching or the printing process, or a metal fabric layer. Hence, a low resistivity is easily obtained. Generally, spaces defined by the mesh-shaped metal layer or the mesh-shaped metal-containing layer are filled by the sealing layer 12, 42, as described above. Hence, transparency and antiglare property are enhanced.

The low refractive index layer 45 constitutes an antireflection layer. That is to say, a composite film, which comprising the antiglare layer and the low refractive layer formed on the antiglare layer, effectively exhibits an antireflection effect. A high refractive index layer may be provided between the low refractive index layer and the antiglare layer. Hence, antireflection function is enhanced.

It is possible to only provide the transparent film and the antiglare layer. In this case, t the low refractive index layer 45, etc can be omitted. The antiglare layer and the anti reflection layer, etc. are generally formed by coating. Coating operation is preferable in view of productivity and economy.

The abovementioned near-infrared absorption layer 46 has a near-infrared radiation blocking function in PDP. Generally speaking, the near-infrared absorption layer contains a pigment having absorption maximum at 800 to 1200nm. The transparent adhesive layer 36 is generally provided for an easy installation to a display. An exfoliative sheet may be provided on the transparent adhesive layer 36.

An optical filter of the present invention is obtained, for example by forming a mesh-shaped metal conductive layer on the entire surface of a rectangle transparent film, and then forming an antiglare layer on the entire area of the mesh-shaped metal conductive layer. If desired, a near-infrared absorption layer is provided on the back surface of the transparent film, and a transparent adhesive layer is provided on the near-infrared absorption layer. Thereafter, if desired, electrode parts may be formed at four edges of entire circumference of the antiglare layer by irradiating a laser to the periphery of the layer.

The above embodiment was an optical filter for a display comprising a single transparent film. Alternatively, two transparent films may be used in the optical filter of the invention. The optical filter can be obtained by the following process:
Namely, a mesh-shaped conductive layer is provided on a first transparent film (which in general has a near-infrared absorption layer or the like on the back side). A second transparent film is provided, which has an antiglare layer and an antireflection layer such as a low refractive index layer on the second transparent film. On the conductive layer provided on the first transparent film, the second transparent film is laminated by the application, if necessary, of an adhesive layer provided at the back side of the second transparent film. A laser is irradiated on the antireflection layer such as the antiglare layer and the low refractive layer, if necessary.
Alternatively, a mesh-shaped metal conductive layer, an antiglare layer and an antireflection layer such as a low refractive layer are provided on a surface of a transparent film in this order, and a near-infrared absorption layer is provided on a surface of another transparent film and a transparent adhesive layer is provided on the near-infrared absorption. Then, the surfaces of two transparent films, where no layers are provided, are bonded with each other. The former laminate can be prepared by a process of the present invention.

The two transparent films are employed when it is favorable for the manufacture. However, it could be disadvantageous to use two transparent films because of bulkiness or the increase of thickness.

Materials used in the optical filter for a display of the present invention are explained below.

The film is generally a transparent film, particularly a transparent plastic film. The materials may be anything having transparency (the transparency meaning transparency to visible light). Examples of the material of the plastic film include polyester such as polyethylene terephthalate (PET) and polybutylene terephthalate, acrylic resin such as polymethyl methacrylate (PMMA), polycarbonate (PC), polystyrene, cellulose triacetate, polyvinyl alcohol, polyvinyl chloride, polyvinylidene chloride, polyethylene, ethylene-vinyl acetate copolymer, polyvinyl butyral, metal-crosslinked ethylene-methacrylic acid copolymer, polyurethane and cellophane. Preferred are polyethylene terephthalate (PET), polycarbonate (PC), polymethyl methacrylate (PMMA), because have high resistance to processing load such as heat, solvent and bending and high transparency. Especially PET is preferred because of excellent processing properties.

The transparent film has generally a thickness of 1 µm to 10 mm, preferably 1µm to 5mm, particularly 25 to 250 µm depending upon the application of the optical filter.

A surface resistance value of the metal conductive layer according to the invention is generally not more than 10 Ω/□, preferably in the range of 0.001 to 5 Ω/□, especially in the range of 0.005 to 5 Ω/□.

Examples of the mesh-shaped (lattice-shaped) conductive layer include a layer obtained by fabricating a metal e.g., a metal fiber and an organic fiber coated with metal into a net shape, a layer obtained by etching a metal (e.g., Cu) layer provided on a transparent film so as to form a mesh having openings, and a layer obtained by printing an electrically conductive ink on a transparent film so as to form a mesh.

It is preferable that the mesh of the mesh-shaped metal conductive layer is comprises the metal fiber and/or the organic fiber coated with metal. It is preferable that the mesh has line width of 1 µm to 1 mm and opening ratio of 40 to 95%. Further preferred is a mesh having line width of 10 to 500 µm and opening ratio of 50 to 95%. When the mesh-shaped conductive layer has a line width more than 1 mm, the electromagnetic wave shielding property is improved, but the opening ratio is decreased. Namely, both the excellent shielding property and opening ratio cannot be obtained. On the other hand, the line width less than 1 µm brings about a mesh with a poor strength that is difficult to handle. Moreover, the conductive layer with an opening ratio of more than 95% is difficult to maintain the shape as a mesh. When the conductive layer has an opening ratio of less than 40%, the optical transparency is decreased, and the light amount from a display is decreased.

The opening ratio (aperture ratio) of the mesh-shaped conductive layer means the proportion of the area of the opening portion to the projected area in the layer.

As the metal of the metal fiber and the organic fiber coated with metal constituting the mesh-shaped conductive layer, copper, stainless steel, aluminum, nickel, titanium, tungsten, tin, lead, iron, silver, carbon or an alloy thereof, preferably copper, stainless, or nickel can be used.

As organic materials of the organic fiber coated with metal, polyester, nylon, vinylidene chloride, aramid, vinylon, or cellulose can be used.

In a patternwise etched conductive foil such as metallic foil, as metals for the metallic foil, copper, stainless steel, aluminum, nickel, iron, brass or alloys thereof, preferably copper, stainless steel or aluminum can be used.

When the thickness of the metal foil is excessively small, the handling property of the foil and the workability of pattern etching are reduced. On the other hand, when the thickness of the metal foil is excessively large, the thickness of the resultant filter is increased and the time required for etching procedure is lengthened. Therefore, the thickness of the conductive layer preferably is in the range of 1 to 200 µm.

The etched pattern may have any shapes. For example, the metallic foil is in the form of a lattice, which is obtained by forming square openings (pores) in a foil, or in the form of a punching metal, which is obtained by forming circle, hexagon, triangle or ellipse openings in a foil. The openings may be regularly arranged or irregularly arranged to have a random pattern. The opening ratio (the proportion of the area of the opening portion to the projected area) of the metal foil is preferably in the range of 20 to 95%. The line width of 1 µm to 1 mm and the opening ratio of 40 to 50% are preferred. The line width of 10 to 500 µm and opening ratio of 50 to 95% are more preferred.

In addition to the above mesh-shaped conductive layer, a mesh-conductive layer can be used. The conductive layer can be obtained by forming dots on a film by using a material soluble in a solvent, and forming a conductive materials layer on the film, the conductive layer including a conductive material insoluble in the solvent. In this way, the film is brought into contact with the solvent, and then the dots and the conductive materials on the dots are removed, to prepare the mesh-shaped conductive layer.

An anchor coat layer may be formed on the surface on which the metal conductive layer is formed. By using the anchor coat layer, the adhesion property between the film and the metal conductive layer can be enhanced. Dots can be formed in high print precision.

The anchor coat layer includes at least a synthetic resin. As the synthetic resin, polyester resin, polyurethane resin, acrylic resin and vinyl acetate resin can be used.

Further, the anchor coat layer preferably includes a silicone oil and a synthetic resin. Such anchor coat layer is formed, for example by applying a coating liquid comprising silicone oil and synthetic resin to the film, with a roll coater. The anchor coat is prepared after being cured by heating.

As examples of silicone oils, dimethyl silicone oil, methyl phenyl silicone oil, methyl hydrogen silicone oil, polyether modified silicone oil, alkyl modified silicone oil, amino modified silicone oil, and epoxy modified silicone oil are used. The content of the silicone oil in the anchor coat layer is preferably in the range of 0.0005 to 5% by weight, particularly in the range of 0.0005 to 0.5% by weight.

Further, the anchor coat layer is more preferably a hardened layer prepared from a composition comprising a synthetic resin having a group having active hydrogen and polyisocyanate having at least two isocyanate groups. Based on the composition, the resistant to solvents can be enhanced.

Examples of the group having active hydrogen include hydroxyl group, primary amino group, secondary amino group and carboxyl group, and preferably hydroxyl group. The equivalent amount of the group having the active hydrogen (e.g. the hydroxyl number) is preferably in the range of 10 to 300 mgKOH/g, particularly in the range of 30 to 100 mgKOH/g, based on the resin (1g).

Examples of the polyisocyanate include aromatic isocyanate such as tolylene diisocyanate (TDI), isophorone diisocyanate, xylylene diisocyanate, diphenylmethane-4,4-diisocyanate; dicyclopentanyl diisocyanate, hexamethylene diisocyanate, 2,4,4'-trimethylhexamethylene diisocyanate, 2,2',4-trimethylhexamethylene diisocyanate. Polyisocyanate based on an isocyanate compound having functionality of 3 or more such as TDI adduct of trimethylolpropane can be also used. Aromatic polyisocyanate is preferred in these polyisocyanate.

A metal plated (metallic deposit) layer may be further provided on the metal conductive layer in order to enhance conductive property (particularly, in case of a method wherein dots are formed by using materials soluble in the abovementioned solvents). The plated layer can be formed by conventional electrolytic plating and nonelectrolytic plating. Examples of the metals used in the plating generally include copper, copper alloy, nickel, aluminum, silver, gold, zinc and tin. Preferred is copper, copper alloy, silver or nickel. Particularly, copper or copper alloy is preferred in view of economic efficiency and conductive property.

Further, antiglare property can be imparted to the conductive layer. For the antiglare treatment, a blackened treatment may be carried out on a surface of the (mesh-shaped) conductive layer. For example, oxidation treatment of metal layer, black plating of chromium alloy, or application of black or dark color ink can be carried out.

The antiglare layer is a layer comprising, as a main component, a synthetic resin and particles. Examples of the synthetic resin are acrylic resin layer, epoxy resin layer, urethane resin layer, silicone resin layer. the thickness is generally in the range of 0.01 to 20 µ m, preferably in the range of 1 to 10 µ m. A portion of the particle is protruded from the surface of the layer. The synthetic resin is, in general, a thermosetting resin or ultraviolet curable resin, and preferably ultraviolet curable resin. Since the ultraviolet curable resin can be cured in a short time, has excellent productivity and is easily removed by a laser, the ultraviolet curable resin is preferably used.

Examples of the thermosetting resin include phenol resin, resorcinol resin, urea resin, melamine resin, epoxy resin, acrylic resin, urethane resin, furan resin and silicon resin.

The antiglare layer is preferably a hardening layer comprising, as a main component, an ultraviolet curable resin composition (comprising ultraviolet curable resin, photopolymerization initiator, and etc.)

Examples of the ultraviolet curable resins (monomers, oligomers) include (meth)acrylate monomers such as 2-hydroxyethyl (meth)acrylate, 2-hydroxyropyl (meth)acrylate, 4-hydroxybutyl (meth)acrylate, 2-ethylhexylpolyethoxy (meth)acrylate, benzyl (meth)acrylate, isobornyl (meth)acrylate, phenyloxyethyl (meth)acrylate, tricyclodecane mono(meth)acrylate, dicyclopentenyloxyethyl (meth)acrylate, tetrahydrofurfuryl (meth)acrylate, acryloylmorpholine, N-vinylcaprolactam, 2-hydroxy-3-phenyloxypropyl (meth)acrylate, o-phenylphenyloxyethyl (meth)acrylate, neopentylglycol di(meth)acrylate, neopentyl glycol dipropoxy di(meth)acrylate, neopentyl glycol hydroxypivalate di(meth)acrylate, tricyclodecanedimethylol di(meth)acrylate, 1,6-hexanediol di(meth)acrylate, nonanediol di(meth)acrylate, trimethylolpropane tri(meth)acrylate, pentaerythritol tri(meth)acrylate, pentaerythritol tetra(meth)acrylate, tris[(meth)acryloxyethyl]isocyanurate and ditrimethylolpropane tetra(meth)acrylate; and
the following (meth)acrylate oligomer such as:
polyurethane (meth)acrylate such as compounds obtained by reaction among the following polyol compound and the following organic polyisocyanate compound and the following hydroxyl-containing (meth)acrylate:
the polyol compound (e.g., polyol such as ethylene glycol, propylene glycol, neopentyl glycol, 1,6-hexanediol, 3-methyl-1,5-pentanediol, 1,9-nonanediol, 2-ethyl-2-butyl-1,3-propanediol, trimethylolpropane, diethylene glycol, dipropylene glycol, polypropylene glycol, 1,4-dimethylolcyclohexane, bisphenol-A polyethoxydiol and polytetramethylene glycol; polyesterpolyol obtained by reaction of the above-mentioned polyol with polybasic acid or anhydride thereof such as succinic acid, maleic acid, itaconic acid, adipic acid, hydrogenated dimer acid, phthalic acid, isophthalic acid and terephthalic acid; polycaprolactone polyol obtained by reaction of the above-mentioned polyol with ε-caprolactone; a compound obtained by reaction of the above-mentioned polyol and a reaction product of the above-mentioned polybasic acid or anhydride thereof and ε-caprolactone; polycarbonate polyol; or polymer polyol), and
the organic polyisocyanate compound (e.g., tolylene diisocyanate, isophorone diisocyanate, xylylene diisocyanate, diphenylmethane-4,4'-diisocyanate, dicyclopentanyl diisocyanate, hexamethylene diisocyanate, 2,4,4'-trimethylhexamethylene diisocyanate, 2,2',4-trimethylhexamethylene diisocyanate), and
the hydroxyl-containing (meth)acrylate (e.g., 2-hydroxyethyl (meth)acrylate, 2-hydroxyropyl (meth)acrylate, 4-hydroxybutyl (meth)acrylate, 2-hydroxy-3-phenyloxypropyl (meth)acrylate, cyclohexane-1,4-dimethylolmono(meth)acrylate, pentaerythritol tri(meth)acrylate or glycerol di(meth)acrylate);
bisphenol-type epoxy(meth)acrylate obtained by reaction of bisphenol-A epoxy resin or bisphenol-F epoxy resin and (meth)acrylic acid.
These compounds can be employed singly or in combination of two or more kinds. The ultraviolet curable resin may be used together with thermo polymerization initiator, i.e., these can be employed as a thermosetting resin.

In the abovementioned ultraviolet curable resin, rigid polyfunctional monomer such as pentaerythritol tri(meth)acrylate, pentaerythritol penta(meth)acrylate, or dipentaerythritol hexa(meth)acrylate is preferably used as a main component, in order to give a hard coat function to the antiglare layer.

Photopolymerization initiators of the ultraviolet curable resin can be optionally selected depending upon the properties of the ultraviolet curable resin used. Examples of the photopolymerization initiators include acetophenone type initiators such as 2-hidroxy-2-methyl-1-phenylpropane-1-on, 1-hydroxycyclohexylphenylketone and 2-methyl-1-[4-(methylthio)phenyl]-2-morphorino-propane-1-on; benzoin type initiators such as benzylmethylketal; benzophenone type initiators such as benzophenone, 4-phenylbenzophenone and hydroxybenzophenone; thioxanthone type initiators such as isopropylthioxanthone and 2,4-diethythioxanthone. Further, as special type, there can be mentioned methylphenylglyoxylate. Especially preferred are 2-hidroxy-2-methyl-1-phenylpropane-1-on, 1-hydroxycyclohexylphenylketone, 2-methyl-1-[4-(methylthio)phenyl]-2-morphorinopropane-1-on and benzophenone. These photopolymerization initiators can be employed together with one or more kinds of a conventional photopolymerization promoter such as a benzoic acid type compound (e.g., 4-dimethylaminobenzoic acid) or a tertiary amine compound by mixing with the promoter in optional ratio. Only the initiator can be employed singly or in combination of two or more kinds. Especially, 1-hydroxycyclohexylphenylketone (Irgercure 184, available from Chiba-Specialty Chemicals) is preferred.

The initiator is preferably contained in the range of 0.1 to 10% by weight, particularly 0.1 to 5% by weight based on the resin composition.

The antiglare layer of the present invention contains particles as described above. The particles may be inorganic particles or organic resin particles. The organic particles are preferred from the standpoint of excellent transparency. Examples of the organic resin particles include cross-linked acrylic resin particles, cross-linked styrene resin particles and cross-linked acrylic-styrene copolymer particles. Examples of the inorganic particles include ITO, TiO₂ ZrO₂ CeO₂, SiO₂, Al₂O₃, Y₂O₃, La₂O₃, LaO and Ho₂O₃. These can be employed singly or in combination of two or more kinds. The fine particles preferably have mean particle size of 1 to 10µm. When the mean particle size is less than 1 µ m, sufficient anti-glare effect cannot be obtained because the protrusion of the particles from the antiglare layer is small. When the mean particle size is more than 10 µ m, it is not preferred, because the visibility can be largely decreased. The amount of the particles is generally in the range of 0.1 to 10% by weight, preferably in the range of 0.1 to 5% by weight based on the resin composition for forming the antiglare layer.

In the antiglare layer, it is preferable that there is substantially no difference between the refractive index of the resin in which the particles are dispersed and that of the particles. Thereby, the light scattering at an interface between the resin and the particles can be inhibited. Accordingly, transparency of the antiglare layer can be enhanced. The difference between the refractive index of the resin and that of the particles in the antiglare layer is preferably not more than 0.03, particularly not more than 0.02.

The refractive index of the resin can be determined, for instance, by using Abbe refractometer (Trade name: DR-M2/1550) available from Atago, Co., Ltd. More precisely, the refractive index of the particles is determined by using solvents. In other words, two solvents having different refractive indexes from each other are mixed at different mixing ratios. The particles are dispersed in the mixed solvents in equal amounts, to obtain dispersions. A dispersion having the smallest turbidity is chosen, and the refractive index of the dispersion is measured by the Abbe refractometer. Thus, the refractive index of the particles is determined.

Further, the antiglare layer may contain a small amount of ultraviolet absorber, infrared absorber, anti-aging agent, paint processing auxiliary agent, colorant, or the like. It is particularly preferable that the antiglare layer contains the ultraviolet absorber (e.g. benzotriazol ultraviolet absorber or benzophenone ultraviolet absorber). By including the ultraviolet absorber, the filter can be efficiently prevented from yellowing or the like. The amount of the ultraviolet absorber is generally in the range of 0.1 to 10% by weight, preferably in the range of 0.1 to 5% by weight based on the resin composition.

The sealing layer 12, 32 formed under the antiglare layer may be the same layer as the antiglare layer or may be a layer comprising the resin used in the antiglare layer (which does not contain particles). When the composition of the sealing layer is the same as that of the antiglare layer except for the particles, the composition can be easily prepared and productivity is enhanced. This is because the identical composition can be used for forming these layers, except for adding the particles to one of these layers.

The thickness of the sealing layer corresponds to the thickness of the mesh, for filling the spaces of the mesh-shaped conductive layer.

The high refractive index layer is preferably a layer (cured layer) in which conductive metal oxide particles (inorganic compound) such as ITO, ATO, Sb₂O₃, SbO₂ In₂O₃, SnO₂, ZnO, Al-doped ZnO, TiO₂ are dispersed in a polymer (preferably ultraviolet curable resin). The conductive metal oxide particle generally has mean particle size of 10 to 10,000 nm, preferably 10 to 50 nm. Especially, ITO (especially mean particle size of 10 to 50nm) is preferred. The high reflective index layer preferably has refractive index of not less than 1.64. The thickness generally is in the range of 10 to 500 nm, preferably 20 to 200 nm.

In the case where the high refractive index layer is a conductive layer, the minimum reflectivity at the surface of the antireflection layer can be reduced to 1.5% or less by increasing the refractive index of the high reflective index layer to 1.64 or more. Further, the minimum reflectivity at the surface of the antireflection layer can be reduced to 1.0% or less by increasing the reflective index of the high reflective index layer to 1.69 or more, preferably a value in the range of 1.69 to 1.82.

The low refractive index layer preferably is a layer (cured layer) in which particles of silica or fluorine resin (preferably hollow silica) are dispersed in a polymer (preferably ultraviolet curable resin). The low refractive index layer contains preferably 10 to 40 % by weight, especially 10 to 30% by weight of the particles. The low refractive index layer preferably has refractive index of 1.40 to 1.51. The refractive index of more than 1.51 brings about reduction of antireflection property of the antireflection film. The thickness of the low refractive index layer is, in general, in the range of 10 to 500 nm, preferably in the range of 20 to 200 nm.

The hollow silica preferably has mean particle size of 10 to 100 nm, preferably 10 to 50 nm, and specific gravity of 0.5 to 1.0, especially 0.8 to 0.9.

To form each layer (antiglare layer, sealing layer or antireflection layer), as described above, the abovementioned particles can be mixed with a resin (preferably ultraviolet curable resin) if necessary. The resultant coating liquid is applied to the surface of the conductive layer formed on the transparent film. Thereafter, the coating liquid is dried and subsequently cured by UV irradiation. In this case, each layer may be formed by coating and cured one by one. Alternatively, all the layers can be successively formed by coating, and then all the layers can be cured entirely.

The formation of the layers is carried out by applying/coating a coating liquid (solution) to a conductive layer or the like. The coating liquid, e.g., a solution comprising an ultraviolet curable resin such as an acrylic monomer in a solvent such as toluene, is applied to the conductive layer or the like, by means of gravure coater. Thereafter, the coated layer is dried, and then cured by exposure to UV rays. This wet-coating method enables high-speed, uniform and cheap film formation. After the coating, for example, the coated layers are exposed to UV rays to be cured, whereby the effects such as improved adhesion and enhanced hardness of the layer can be obtained.

In the UV- rays curing, it is possible to adopt, as light source used, various sources generating light in the wavelength range of ultraviolet to visible rays. Examples of the source include super-high-pressure, high-pressure and low-pressure mercury lamps, a chemical lamp, a xenon lamp, a halogen lamp, a mercury halogen lamp, a carbon arc lamp, and an incandescent electric lamp, and laser beam. The exposing time is generally in the range of a few seconds to a few minutes, depending upon kinds of lamp and strength of light. To promote the curing, the laminate may be heated beforehand to a temperature in the range of 40 to 120°C, and then the heated laminate may be exposed to ultraviolet rays.

The near-infrared absorption layer is generally obtained by forming a layer containing a dye on a surface of the transparent film. The near-infrared absorption layer is prepared by applying a coating liquid, which comprises an ultraviolet- or electron-beam- curable resin or thermosetting resin, and the dye and binder resin, to a conductive layer or the like. The layer is completed, if desired, by drying and curing the layer. Alternatively, it is possible to prepare the absorption layer from the coating liquid comprising the dye, binder resin and the like, followed only by drying. When the near-infrared absorption layer is used as a film, it is generally a near-infrared cut film, such as dye-containing film. The dye generally has absorption maximum in wavelength of 800 to 1200 nm. Examples of the dye include phthalocyanine dyes, metal complexes dyes, nickel dithioren complexes dyes, cyanine dyes, squalirium dyes, polymethine dyes, azomethine dyes, azo dyes, polyazo dyes, diimmonium dyes, aminium dyes, anthraquinone dyes. Preferred are cyanine dyes, phthalocyanine dyes and diimmonium dyes. These dyes can be employed singly or in combination. Examples of the binder resin include thermoplastic resin such as acrylic resin.

In the invention, a neon-emission absorption function may be given to the near-infrared absorption layer such that the near-infrared absorption layer has function for adjusting color hue. For this purpose, a neon-emission absorption layer may be provided, or a neon-emission selective absorption dye is added to the near-infrared absorption layer.

Examples of the neon-emission selective absorption dyes include cyanine dyes, squalirium dyes, anthraquinone dyes, phthalocyanine dyes, polymethine dyes, polyazo dyes, azulenium dyes, diphenylmethane dyes, triphenylmethane dyes. The neon-emission selective absorption dyes are required to have neon-emission selective absorption function at wavelength of approx. 585 nm. It is also necessary for the neon-emission selective absorption dyes to have a small absorption in the visible light wavelength range except for the above-mentioned wavelength. Hence, the dyes preferably have absorption maximum wavelength of 575 to 595 nm having spectrum half bandwidth of 40 nm or less.

It is possible to use a plurality of absorption dyes including dyes for absorbing near-infrared light and dyes for absorbing neon emission light are used in combination. In that case, it is not necessary for all the absorption dyes to be contained in the same layer, and the absorption dyes can be added to different layers. Such separate addition can be considered, especially when the dyes have insufficient solubilities, the mixed dyes react with each other, or the thermal resistance or moisture resistance of the layer is deteriorated by the mixed application.

Further, coloring materials, ultraviolet absorbers, and antioxidants may be added unless these materials adversely affect the optical properties of the filter.

As to the near-infrared absorption properties of the optical filter of the invention, the transmittance of light in a wavelength range of 850 to 1000 nm preferably is 20% or lower, more preferably 15% or lower. As to the selective absorption properties of the optical filter, the transmittance of light at a wavelength of 585 nm preferably is 50% or lower. The former is effective for reducing the transmittance of a light in the wavelength range, which is considered to cause malfunction of remote control systems in peripheral devices. In the latter case, it is effective to absorb orange light having a peak wavelength in the range of 575 to 595 nm, which affects to the deterioration of color reproductively. Accordingly, red light is rendered more intrinsic, and the reproducibility of colors is improved.

The near-infrared absorption layer generally has thickness of 0.5 to 50 µm.

When the conductive adhesive tape is attached to the conductive layer having an exposed periphery, a material including an adhesive layer on one surface of a metal foil can be used as the conductive adhesive tape. In the adhesive layer, conductive particles are included in a dispersed state. For the adhesive layer, acrylic adhesive, rubber adhesive or silicon adhesive, or an epoxy or phenol resin adhesive including a curing agent can be used.

Various particles can be used as the conductive particles to be dispersed in the adhesive layer, as long as the particles are excellent electrical conductors. For examples, powder of metal such as copper, silver or nickel, and resin powder or ceramic powder coated with these metals can be used. Further, there is no limitation in shape, and any shape such as bulb, dendriform, grain and pellet can be employed.

The amount of the conductive particles is preferably in the range of 0.1 to 15 % by volume based on the polymer constituting the adhesive layer, and the mean particle size is preferably in the range of 0.1 to 100 µm. Concentration/aggregation of the conductive particles is prevented and excellent conductivity can be obtained by the above-prescribed amount and the particle size.

As the metal foil for forming a substrate of the conductive adhesive tape, copper, silver, nickel, aluminum and stainless steel can be used. The thickness of the foil is usually in the range of 1 to 100 µ m.

The adhesive layer can be easily formed by applying the above adhesive which is uniformity mixed with the conductive particles at a predetermined ratio to the metal foil by a roll coater, a die coater, a knife coater, a micabar coater, a flow coater, a spray coater, or the like.

The adhesive layer generally has the thickness of 5 to 100 µ m.

In stead of the conductive adhesive tape, an adhesive agent made of the above material for the adhesive layer may be coated to the exposed area of the conductive layer, and the above-mentioned conductive tape may be further attached thereto.

The transparent adhesive layer of the invention is used for bonding the optical filter of the invention to a display, and therefore any resin having adhesion function can be used as materials for forming the adhesive layer. Examples of the material include acrylic adhesives made of butyl acrylate and the like, rubber adhesives, TPE (thermoplastic elastomer) adhesives comprising as a main component TPE such as SEBS (styrene/ethylene/butylene/styrene) and SBS (styrene/ butadiene/styrene).

The thickness of the transparent adhesive layer is generally in the range of 5 to 500 µm, preferably in the range of 10 to 100 µm. The optical filter can be generally bonded to a glass plate of a display through the adhesive layer under application of pressure thereto.

In case of using two transparent films in the invention, examples of materials (adhesives) used in the adhesion of the films include ethylene/vinyl acetate copolymer, ethylene/methyl acrylate copolymer, acrylic resin (e.g., ethylene/(meth)acrylic acid copolymer, ethylene/ethyl (meth)acrylate copolymer, ethylene/methyl (meth)acrylate copolymer, metal-ion crosslinked ethylene/(meth)acrylic acid copolymer), and ethylene copolymers such as partially saponified ethylene/vinyl acetate copolymer, carboxylated ethylene/vinyl acetate copolymer, ethylene/(meth)acrylic acid/maleic anhydride copolymer, ethylene/vinyl acetate/(meth)acrylate copolymer. The (meth)acrylic acid means acrylic acid and methacrylic acid and the (meth)acrylate means acrylate and meth acrylate. Besides these polymers, there can be mentioned polyvinyl butyral (PVB) resin, epoxy resin, phenol resin, silicon resin, polyester resin, urethane resin, rubber adhesives, thermoplastic elastomer (TPE) such as SEBS (styrene/ethylene/butylene/styrene) and SBS (styrene/butadiene/styrene). The acrylic adhesives and epoxy resins are preferred because they show excellent adhesion.

The thickness of the above-mentioned adhesive layer generally is in the range of 10 to 50 µm, preferably in the range of 20 to 30 µm. The optical filter can be generally attached to a glass plate of a display through the adhesive layer by application of pressure and heat thereto.

In the case where EVA (ethylene/vinyl acetate/ ethylene copolymer) is used as materials of the transparent adhesive layer, EVA generally has the content of vinyl acetate in the range of 5 to 50 % by weight, especially 15 to 40 % by weight. When the content is less than 5 % by weight, the layer does not show satisfactory transparency. On the other hand, when the content is more than 40 % by weight, the mechanical strength of the layer is extremely decreased, the film formation is made difficult, and the blocking between films readily occurs.

As a crosslinking agent for thermo crosslinking, an organic peroxide is generally suitable. The organic peroxide is selected in the consideration of sheet-processing temperature, crosslinking/curing (bonding) temperature, and storage stability. Examples of the organic peroxide include 2,5-dimethylhexane-2,5-dihydroperoxide, 2,5-dimethyl-2,5-(t-butylperoxy)hexyne-3, di-t-butylperoxide, t-butylcumyl peroxide, 2,5-dimethyl-2,5-di(t-butylperoxy)hexane, dicumyl peroxide, α,α'-bis(t-butylperoxyisopropyl)benzene, n-butyl-4,4-bis(t-butylperoxy)valerate, 2,2-bis(t-butylperoxy)butane, 1,1-bis(t-butylperoxy)cyclohexane, 1,1-bis(t-butylperoxy)-3,3,5-trimethylcyclohexane, t-butylperoxybenzoate, benzoyl peroxide, t-butylperoxyacetate, 2,5-dimethylhexyl-2,5-bis(t-butylperoxy)hexyne-3, 1, 1-bis(t-butylperoxy)-3,3,5-trimethylcyclohexane, 1,1-bis(t-butylperoxy)cyclohexane, methyl ethyl ketone peroxide, 2,5-dimethylhexyl-2,5-bisperoxybenzoate, t-butylhydroperoxide, p-menthane hydroperoxide, p-chlorobenzoyl peroxide, t-butylperoxyisobutylate, hydroxyheptyl peroxide and chlorohexanone peroxide. The organic peroxide can be used singly, or in combination of two or more kinds. The content of the organic peroxide is generally used in an amount of not more than 5 parts by weigh, preferably 0.5 to 5.0 parts by weight based on 100 parts by weight of EVA.

The organic peroxide is generally kneaded with EVA by means of an extruder or a roll mill. Alternatively, the organic peroxide may be solved in an organic solvent, plasticizer, vinyl monomer and the thus obtained solution may be added to an EVA film by means of impregnation method.

The EVA may contain acryloyl group-containing compounds, methacryloyl group-containing compounds, allyl group-containing compounds for improvement of various properties of EVA (e.g., mechanical strength, optical characteristics, adhesive property, weather resistance, whitening resistance, rate of crosslinking).
Typical examples of the acryloyl and methacryloyl group-containing compounds include derivatives of acrylic acid or methacrylic acid, such as esters and amides of acrylic acid or methacrylic acid. Examples of the ester residue include linear alkyl groups (e.g., methyl, ethyl, dodecyl, stearyl and lauryl), a cyclohexyl group, a tetrahydrofurfuryl group, an aminoethyl group, a 2-hydroxyethyl group, a 3-hydroxypropyl group, and 3-chloro-2-hydroxtpropyl group. Further, the esters include esters of acrylic acid or methacrylic acid with polyhydric alcohol such as ethylene glycol, triethylene glycol, polypropylene glycol, polyethylene glycol, trimethylol propane or pentaerythritol. Representative example of the amide is diacetone acrylamide.

Examples of the esters include polyfunctional esters of acrylic acids or methacrylic acids with polyhydric alcohol such as glycerol, trimethylol propane or pentaerythritol; and further allyl group-containing compounds such as triallyl cyanurate, triallyl isocyanurate, diallyl phthalate, diallyl isophthalate and diallyl maleate. The compounds can be used singly, or in combination of two or more kinds. The content of the compound is generally used in an amount of 0.1 to 2 parts by weight, preferably 0.5 to 5 parts by weight based on 100 parts by weight of EVA.

In case EVA is cured by light, sensitizer (photoinitiator) is used instead of the organic peroxide, and it is generally used in an amount of not more than 5 parts by weight, preferably 0.1 to 3.0 parts by weight based on 100 parts by weight of EVA.

Examples of the sensitizer include benzoin, benzophenone, benzoin methyl ether, benzoin ethyl ether, benzoin isopropyl ether, benzoin isobutyl ether, dibenzyl, 5-nitroacenaphtene, hexachlorocyclopentadiene, p-nitrodiphenyl, p-nitroaniline, 2,4,6-trinitroaniline, 1,2-benzanthraquinone, 3-methyl-1,3-diaza-1,9-benzanthrone. The photoinitiators can be used singly, or in combination of two or more kinds.

In the invention, a silane coupling agent may be used to accelerate adhesion. Examples of the silane coupling agent include vinylethoxysilane, vinyltris(β-methoxyethoxy)silane, γ-(methacryloxypropyl)trimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, γ-chloropropylmethoxysilane, vinyltrichlorosilane, γ-mercaptopropylmethoxysilane, γ-aminopropyltriethoxysilane, N-β-(aminoethyl)-γ-aminopropyltrimethoxysilane.

The silane coupling agent can be used singly, or in combination of two or more kinds. The content of the silane coupling agent is generally in an amount of 0.001 to 10 parts by weight, preferably 0.001 to 5 parts by weight based on 100 parts by weight of EVA.

The EVA adhesive layer of the invention can further contain a small amount of ultraviolet absorbing agent, infrared absorbing agent, age stabilizer (antioxidant), paint processing aid and colorant. If appropriate, filler such as carbon black, hydrophobic silica or calcium carbonate may be contained.

The adhesive layer for adhesion can be obtained, for example, by mixing EVA with the above-mentioned additives and kneaded by means of extruder or roll, and then forming the sheet having a predetermined shape by film formation method using calendar, roll, T-die extrusion or blowing.

A protective layer may be provided on the antireflection layer. The protective layer is preferably formed in the same manner as in the hard coat layer.

Materials for the release sheet provided on the transparent adhesive layer are generally transparent polymers having glass transition temperature of not less than 50°C. Examples of the materials include polyester resin (e.g., polyethylene terephthalate, polycyclohexylene terephthalate, polyethylene naphthalate), polyamide resin (e.g., nylon 46, modified nylon 6T, nylon MXD6, polyphthalamide), ketone resin (e.g., polyphenylene sulfide, polythioether sulfone), sulfone resin (e.g., polysulfone, polyether sulfone), polyether nitrile, polyarylate, polyether imide, polyamideimide, polycarbonate, polymethyl methacrylate, triacetylcellulose, polystyrene or polyvinyl chloride. Of these resins, polycarbonate, polymethyl methacrylate, polyvinyl chloride, polystyrene and polyethylene terephthalate can be preferably employed. The thickness is generally in the range of 10 to 200 µm, especially in the range of 30 to 100 µm.

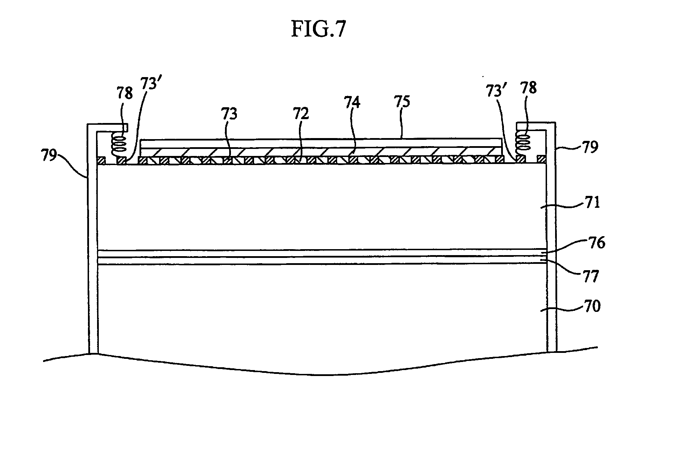

Fig 7 shows an embodiment where an optical filter of the present invention is attached to image-displaying surface of a plasma display panel, that is a kind of display. An optical filter is attached to a display surface of a display panel 70. That is to say, an optical filter is provided on a display surface of the display panel 70, the optical filter having a mesh-shaped conductive layer 73, a sealing layer 72, an antiglare layer 74 and an anti-reflection layer 75 such as a low refractive index layer are formed on one surface of a transparent film 71 in this order. In this embodiment, a near-infrared absorption layer 76 and a transparent adhesive layer 77 are formed on the other surface of the transparent film 71. The mesh-shaped conductive layer 73' is exposed at periphery (marginal parts) of the filter. The exposed mesh-shaped layer 73' and a metal cover 79 provided on the periphery of the plasma display panel 70 are in a contact state with each other via shield fingers (metal members in the form of leaf springs) 78. Instead of the shield fingers, conductive gaskets or the like may be used. Thereby, the electric conduction between the optical filter and the metal cover 79 are conducted, and earth/ground is performed. The metal cover 79 may be a metal frame. As is obvious from Fig 7, the mesh-shaped conductive layer 73 is directed toward the viewer's side. The metal cover 79 covers the area of about 2 to 20 mm from the periphery of the conductive layer 73. Further, the shape of the metal cover 79 can be altered, and the metal cover 79 can directly contact the mesh-shaped conductive layer 73.

In the PDP display apparatus of the invention, since the optical filter generally has a plastic film as a substrate, it is possible to directly attach the optical filter to the surface of the glass plate of the PDP as described above. Therefore, PDP itself can be reduced in weight, thickness and cost, especially in case of using one transparent film. Further, compared with PDP having a front plate of a transparent molded body in front of the PDP, it is possible in the present invention to remove an air layer having a low refractive index formed between PDP and a filter for PDP. Therefore, the PDP of the invention does not have shortcomings such as the increase of visible-rays reflectivity caused by the interface reflection and the occurrence of the double reflection. Thus, the PDP of the invention has an improved visibility.

Thus, the display provided with the optical filter of the invention has excellent antireflection property and antistatic property. Further, the display scarcely generates a radiation of dangerous electromagnetic wave, and is easily viewable, free from dust attachment, and safe.

The invention is illustrated in detail by using the following Examples and Reference Example. The invention is not restricted to the following Examples.

### [Example 1]

### <Preparation of optical filter for display>

### (1) Formation of mesh-shaped metal conductive layer

A copper foil having thickness of 3 µ m was attached to the entire surface of an adhesive layer (polyester polyurethane; thickness of 20 nm) provided on the surface of a lengthy polyethylene terephthalate film (thickness of 100 µ m, width of 600mm, length of 100m). The copper foil was processed into a lattice pattern by means of photolithography.

The conductive layer on the surface of the film had line width of 30 µ m, pitch of 127 µm and opening ratio of 58%. The mean thickness of the conductive layer (copper layer) was 3 µ m.

### (2) Formation of antiglare layer

The following components:

| | |
|---|---|
| Pentaerythritol triacrylate (NK ester A-TMM-3L, Shin Nakamura Chemical Co., Ltd., refractive index: 1.49) | 200 parts by weight |
| ITO (mean particle size: 150nm) | 20 parts by weight |
| Acrylic beads (mean particle size: 5 µ m, refractive index: 1.49, trade name: MX-500, Soken Chemical & Engineering Co., Ltd.) | 3 parts by weight |
| IPA | 100 parts by weight |
| Cyclohexanone | 100 parts by weight |
| Irgacure 184 (Available from Ciba specialty chemicals) | 6 parts by weight |

were mixed with each other to form a coating liquid, which was applied to the entire surface of the mesh-shaped metal conductive layer with a bar coater, and cured by UV irradiation. Hence, an antiglare layer having thickness of 4 µ m (refractive index: 1.48) was formed on the mesh-shaped metal conductive layer.

Thus, an optical filter for a display was obtained.

### [Example 2]

### <Preparation of optical filter for display>

### (1) Formation of mesh-shaped metal conductive layer

A copper foil having thickness of 10 µm was attached on an entire surface of an adhesive (polyester polyurethane, thickness of 20 nm) layer provided on a lengthy polyethylene terephthalate film (thickness of 100 µ m, width of 600 mm, length of 100 m). The copper foil was processed into a lattice pattern by means of photolithography.

The conductive layer on the surface of the film had line width of 30 µ m, pitch of 127 µ m and opening ratio of 58%. The mean thickness of the conductive layer (copper layer) was 10 µ m.

### (2) Formation of sealing layer and antiglare layer

The following components:

| | |
|---|---|
| Pentaerythritol triacrylate (NK ester A-TMM-3L, Shin-Nakamura Chemical Co., Ltd., refractive index: 1.49) | 200 parts by weight |
| ITO (mean particle size: 150 nm) | 20 parts by weight |
| Acrylic beads (mean particle size: 3 µ m, refractive index: 1.49, trade name: MX-300TA, Soken Chemical & Engineering Co., Ltd.) | 3 parts by weight |
| IPA | 100 parts by weight |
| Cyclohexanone | 100 parts by weight |
| Irgacure 184 (Available from Ciba specialty chemicals) | 6 parts by weight |

were mixed with each other to form a coating liquid 1. Subsequently, a coating liquid 2 was prepared in the same manner as above, except that the acrylic beads were not used.

The coating liquid 2 was applied to the entire surface of the mesh-shaped metal conductive layer with a bar coater, and cured by UV irradiation. Hence, a sealing layer having thickness of 10 µ m was formed on (spaces of) the mesh-shaped metal conductive layer. Subsequently, the coating liquid 1 was applied to the surfaces of the mesh-shaped metal conductive layer and the sealing layer with the bar coater, and cured by UV irradiation. Hence, an antiglare layer having thickness of 2 µm was formed on the mesh-shaped metal conductive layer.

Thus, an optical filter for a display was obtained.

### [Example 3]

### <Formation of optical filter for display>

The following layers ware further formed on the optical filter obtained in Example 1. A coating liquid of the following formulation for preparing an anchor coat layer was applied to an adhesive layer provided on the surface of a lengthy polyethylene terephthalate film (thickness of 100 µ m, width of 600 mm, length of 100 m). After drying, an anchor coat layer with a thickness of 0.2 µm was formed.

### (Formulation)

Polyester solution (solid content: 40% by weight,

| | |
|---|---|
| Trade name: AD335AE, available from Toyo Morton Co., Ltd) | 100 parts by weight |
| Polyisocyanate solution (solid content: 53% by weight Trade name: CAT-10L, available from Toyo Morton Co., Ltd) | 6.5 parts by weight |
| Toluene | 250 parts by weight |
| Methyl ethyl ketone | 250 parts by weight |

A 20% of polyvinyl alcohol aqueous solution was printed in dot pattern on the resultant anchor coat layer. Each dot had a square shape having a length of each side of 127 µm. The distance between the dots was 30µm, and the arrangement of the dots was in the form of a square grid (lattice). The print thickness was approx. 4µm after drying.

On the PET film having the above dot pattern, copper was vacuum-deposited to form a copper layer having mean thickness of 3µm. Subsequently, the PET film having dot pattern and copper layer was immersed in room-temperature water and the dots were dissolved and removed by rubbing the same with a sponge, and then the PET film was rinsed with water, dried to form a mesh-shaped conductive layer on the entire surface of the PET film.

The metal conductive layer on the PET film showed pattern of square grid (mesh) precisely corresponding to negative pattern for the dot pattern. The line width of the mesh was 30 µm, the pitch was 127 µm, and the opening ratio was 58%. Further mean thickness of the conductive layer (copper layer) was 3µm.

### (2) Formation of antiglare layer

The following components:

| | |
|---|---|
| Pentaerythritol triacrylate (NK ester A-TMM-3L, available from Shin Nakamura Chemical Co., Ltd., refractive index: 1.49) | 200 parts by weight |
| ITO (mean particle size: 150nm) | 20 parts by weight |
| Acrylic beads (mean particle size: 5 µm, refractive index: 1.49, Trade name: MX-500, available from Soken Chemical & Engineering Co., Ltd.) | 3 parts by weight |
| IPA | 100 parts by weight |
| Cyclohexanone | 100 parts by weight |
| Irgacure 184 (Available from Ciba specialty chemicals) | 6 parts by weight |

were mixed with each other to form a coating liquid. The coating liquid was applied to the entire surface of the mesh-shaped metal conductive layer with a bar coater, and cured by UV irradiation. Hence, an antiglare layer having thickness of 4 µ m (refractive index: 1.48) was formed on the mesh-shaped metal conductive layer.

Thus, an optical filter for a display was obtained.

### [Reference Example 1]

### <Formation of optical filter for display>

An optical filter for a display was obtained in the same manner as in Example 3 except that CAT-10L was not used in formulation of an anchor coat layer.

### [Evaluation of optical filter]

### (1) The height from the surface of the film to the surface of the antiglare layer (the thickness of the antiglare layer), and the height from the surface of the antiglare layer to the surface of the projected particles.

The height from the surface of the film to the surface of the anti-glare layer (the thickness of the antiglare layer) was calculated from a difference obtained by measuring the surface of the film and the surface of the antiglare layer formed on the surface of the film by using a surface roughness meter (trade name: SURFCOM480A available from Tokyo Seimitsu Co., Ltd) in accordance with JIS B0601-2001.

The height from the surface of the antiglare layer to the surface of the exposed particles can be calculated from a profile curve obtained by measuring by using the surface roughness meter (trade name: SURFCOM480A available from Tokyo Seimitsu Co., Ltd) in accordance with JIS B0601-2001. This was carried out at the measurement length of 2 mm.

### (2) Transmission image sharpness

Transmission image sharpness was determined in accordance with JIS-K-7105.

### (3) Reflection image sharpness (reflection angle: 45 degrees)

Reflection image sharpness was determined in accordance with JIS-K-7105.

### (4) Haze value of optical filter

The haze value was determined by using Full Automatic Direct-Reading Haze Computer (HGM-2DP; manufactured by Suga Shikenki K.K.) according to JIS K 7105 (1981).

### (5) Ra of antiglare layer

Ra of the antiglare layer was determined in the same manner as in (1).

The obtained results were shown in Table 1.

**Table 1**

| | Thickness of anti-glare layer | Height of projected particles (projection ratio%) | Transmission image sharpness | Reflection image sharpness | Haze | Ra |
|---|---|---|---|---|---|---|
| | | | | | (%) | (µm) |
| Example 1 | 4 µm | 1 µm -20% | 182 | 56 | 3.5 | 0.15 |
| Example 2 | 2 µm | 1 µm -33% | 190 | 50 | 3 | 0.11 |
| Example 3 | 4.3 µm | 0.7 µm -14% | 188 | 50 | 3.5 | 0.13 |
| Example 4 | 4.3 µm | 0.7 µm -14% | 188 | 50 | 10 | 0.13 |

PDP filters obtained in Examples 1 to 3 had comparable transparency and electromagnetic wave shielding property, with respect to the conventional filter. Moreover, the PDP filters of Examples 1 to 3 showed an excellent productivity in the PDP manufacture, that was superior to the conventional filter.

Another optical filter was produced as follows, which additionally had further functional layers in the optical filter of Example 3.

### [Example 4]

### <Formation of optical filter for display>

The following layers were further included in the optical filter obtained in Example 3.

### (3) Formation of low refractive layer

The following components:

| | |
|---|---|
| OPSTAR JN-7212 (Available from JSR Corporation) | |
| | 100 parts by weight |
| Methyl ethyl ketone | 117 parts by weight |
| Methyl isobutyl ketone | 117 parts by weight |

were mixed with each other to form a coating liquid. The coating liquid was applied to the abovementioned hard coat layer with a bar coater, and dried in an oven at 80°C for five minutes, and then cured by UV irradiation. Hence, a low refractive layer having thickness of 90 nm (refractive index: 1.42) was formed on the hard coat layer.

### (4) Formation of near-infrared absorption layer (having color hue adjusting function)

The following components:

| | |
|---|---|
| Polymethyl methacrylate | 30 parts by weight |
| TAP-2 | |
| (available from Yamada Chemical Co., Ltd.) | 0.4 parts by weight |
| Plast Red 8380 | |
| (available from Arimoto Chemical Co., Ltd.) | 0.1 part by weight |
| CIR-1085 | |
| (available from Japan Carlit Co., Ltd.) | 1.3 parts by weight |
| IR-10A | |
| (available from Nippon Syokubai Co., Ltd.) | 0.6 parts by weight |
| Methyl ethyl ketone | 152 parts by weight |
| Methyl isobutyl ketone | 18 parts by weight |

were mixed with each other to form a coating liquid. The coating liquid was applied to entirely to a bottom surface of the abovementioned polyethylene film with a bar coater, and dried in an oven at 80°C for five minutes. Hence, a near-infrared absorption layer (having color hue adjusting function) having thickness of 5 µm was formed on the polyethylene film.

### (5) Formation of transparent adhesive layer

The following components:

| | |
|---|---|
| SK Dyne 1811L | |
| (Available from Soken Chemical & Engineering Co., Ltd.) | |
| | 100 parts by weight |
| Hardener L-45 | |
| (Available from Soken Chemical & Engineering Co., Ltd.) | |
| | 0.45 parts by weight |
| Toluene | 15 parts by weight |
| Ethyl acetate | 4 parts by weight |

were mixed with each other to form a coating liquid. The coating liquid was applied to the abovementioned near-infrared absorption layer with a bar coater. Hence, a transparent adhesive layer having thickness of 25 µm was formed on the near-infrared absorption layer.

Thus, an optical filter for a display was obtained.

When the PDP filter obtained in Example 4 was attached to PDP and an image was displayed on the PDP, a good image was obtained.

## Claims

1. An optical filter for a display comprising:
a structure comprising a film and a mesh-shaped metal conductive layer provided on one surface of the film; and
an antiglare layer provided on the one surface of the mesh-shaped metal conductive layer, the antiglare layer comprising a resin and fine particles dispersed in the resin, the fine particles protruding from the surface of the antiglare layer.

2. An optical filter for a display comprising:
a structure comprising a film and a mesh-shaped metal conductive layer provided on one surface of the film;
a sealing layer for filling spaces of the mesh defined by the mesh-shaped metal conductive layer, the sealing layer being provided on the one surface of the mesh-shaped metal conductive layer; and
an antiglare layer provided on the sealing layer, the antiglare layer comprising a resin and fine particles dispersed in the resin, the fine particles protruding from the surface of the antiglare layer.

3. An optical filter for a display as defined in claim 1 or 2, wherein thickness of the antiglare layer is smaller than the mean particle size of the fine particles.

4. An optical filter as defined in any of claims 1 to 3, wherein one of the antiglare layer and a combination of the sealing layer and the antiglare layer is formed by applying a coating liquid comprising an organic solvent, the fine particles and the resin being dispersed in the organic solvent.

5. An optical filter as defined in any of claims 1 to 4, wherein the haze value of the filter is not more than 10%.

6. An optical filter as defined in any of claims 1 to 5, wherein the fine particles are organic resin particles or inorganic particles.

7. An optical filter as defined in claim 6, wherein the organic resin particles are at least one kind of particles selected from a group consisting of cross-linked acrylic resin particles, cross-linked styrene resin particles and cross-linked acrylic-styrene copolymer particles.

8. An optical filter as defined in any of claims 1 to 7, wherein the resin in the antiglare layer is a ultraviolet curable resin.

9. An optical filter as defined in any of claims 1 to 8, wherein the refractive index of the resin in the antiglare layer is free from a substantial difference from that of the fine particles therein.

10. An optical filter as defined in any of claims 1 to 9, wherein the difference between the refractive index of the resin in the antiglare layer and that of the fine particles is not more than 0.03.

11. An optical filter as defined in any of claims 2 to 10, wherein the sealing layer has the same composition as that of the antiglare layer

12. An optical filter as defined in any of claims 1 to 11, wherein the antiglare layer functions as a hard coat layer.

13. An optical filter as defined in any of claims 1 to 12, wherein the mean height from the surface of the antiglare layer to the surface of the protruded fine particles is 10 to 40% of the mean particle size of the fine particles.

14. An optical filter for a display as defined in any of claims 1 to 13, wherein the transmission image sharpness established in JIS-K-7105 is not less than 150.

15. An optical filter for a display as defined in any of claims 1 to 14, wherein the reflection image sharpness (reflection angle: 45 degrees) established in JIS-K-7105 is not more than 100.

16. An optical filter for a display as defined in any of claims 1 to 15, wherein the surface roughness (Ra) of the antiglare layer is in the range of about 0.05 to about 0.6 µm.

17. An optical filter for a display as defined in any of claims 1 to 16, wherein the optical filter is used as a plasma display panel optical filter.

18. An optical filter for a display as defined in any of claims 1 to 17, further comprising a glass substrate, and the film in the structure being provided on the glass substrate so that the other surface of the substrate is in contact with a surface of the glass substrate.

19. A display comprising the optical filter for a display as defined in any of claims 1 to 18.

20. A plasma display panel comprising the optical filter for a display as defined in any of claims 1 to 18.
